# EUROPEAN PATENT APPLICATION

(11) **EP 2 204 824 A1**
(43) Date of publication of application: **07.07.2010**
(21) Application number: 08842232.4
(22) Date of filing: 20.10.2008
(51) Int. Cl.: H01B 13/00, H01B 1/00, H01B 1/22, H01L 21/28, H01L 21/288, H01L 21/3205, H01L 23/52, H05K 3/10

(54) **METHOD OF FORMING COPPER WIRING PATTERN AND COPPER OXIDE PARTICLE DISPERSION FOR USE IN THE SAME**

(30) Priority: 22.10.2007 JP 2007273779
(71) Applicant: Hitachi Chemical Company, Ltd., Tokyo 163-0449 (JP)
(72) Inventor: NAKAKO, Hideo, Ibaraki 300-4247 (JP); YAMAMOTO, Kazunori, Ibaraki 300-4247 (JP); MACHII, Youichi, Ibaraki 300-4247 (JP); KUMASHIRO, Yasushi, Ibaraki 300-4247 (JP); YOKOZAWA, Shunya, Tokyo 163-0449 (JP); EJIRI, Yoshinori, Ibaraki 308-8521 (JP); MASUDA, Katsuyuki, Ibaraki 308-8521 (JP)
(74) Representative: Albrecht, Thomas
(86) International application number: PCT/JP2008/068960
(87) International publication number: WO 2009/054343

(57) **Abstract**

There are provided are a method wherein a surface treating agent, which is essential for making copper particles antioxidative and dispersing the copper particles in the prior art, is hardly used but copper particles, which cause little electromigration and are small in the price rate of material itself, are used to form a low-resistance copper wiring pattern while the generation of cracks therein is restrained; and a copper oxide particle dispersed slurry used therein.

The method is a method for forming a copper wiring pattern including the step of using a dispersion slurry wherein copper based particles having a copper oxide surface are dispersed to form any pattern over a substrate, and the step of reducing the copper oxide surface of the copper based particles in the pattern with atomic form hydrogen to return the oxide to copper, and sintering particles of the copper metal generated by the reduction and bonding the particles to each other.

## Description

### Technical Field

The present invention relates to a method for forming a copper wiring pattern, using nanoparticles having a copper oxide surface, and copper oxide particle dispersed slurry used therein.

### Background Art

The formation of a wiring pattern by printing has been considered to be promising because of low energy, low costs, high throughput, on-demand production, and other superiorities. This purpose is realized by using an ink paste containing a metal element to form a pattern by printing, and then giving metallic conductivity to the printed wiring pattern.
Hitherto, for this purpose, a paste has been used wherein silver or copper in a flake form is incorporated, together with an organic solvent, a curing agent, a catalyst and so on, into a binder of a thermoplastic resin or thermosetting resin. The use method of this metal paste is conducted by painting the paste onto a target object with a disperser or by screen printing, and then drying the resultant at normal temperature or heating the resultant to about 150°C to cure the binder resin, thereby producing an electroconductive coat. The volume resistivity of the thus-obtained electroconductive coat, which is varied by conditions for forming the coat, is from 10⁻⁶ to 10⁻⁷ Ωm, and is a value which is from 10 to 100 times larger than the volume resistivity of metallic silver or copper, which is 16 xx 10⁻⁹ Ω m or 17 × 10⁻⁹ Ω m, respectively. Thus, the value is a value that is never comparable to the electroconductivity of metallic silver or copper. The reason why the electroconductivity of such a conventional electroconductive coat made of a silver or copper paste is low is that: inside the electroconductive coat obtained from the silver or copper paste, only some parts of the metal particles physically contact each other so that the number of the contact points is small; the contact points have contact resistance; and further the binder remains between some parts of the silver particles so that the silver particles are hindered from contacting each other directly. Furthermore, about conventional silver paste, the silver particles are in the form of flakes having a particle diameter of 1 to 100 µm; thus, it is impossible in principle to print any wiring having a line width not more than the particle diameter of the flake-form silver particles. Additionally, an ink using particles having a particle diameter of 100 nm or less has been desired in order to make wiring fine or apply the ink to ink-jetting. From these viewpoints, any conventional silver paste is improper for forming a fine wiring pattern.

As a method for overcoming these drawbacks of silver or copper paste, a wiring pattern forming method using metal nanoparticles has been investigated. The method using gold or silver nanoparticles has been established (see, for example, Patent Documents 1 and 2). Specifically, by drawing a very fine circuit pattern by use of a dispersion slurry containing gold or silver nanoparticles and then sintering the metal nanoparticles so as to be bonded to each other, it is possible in the resultant sintered wiring layer to form wiring wherein the wiring line width and the space-distance between the wiring lines are each from 5 to 50 µm, and the volume resistivity is 1 × 10⁻⁸ Ωm or less. However, when nanoparticles of a noble metal, such as gold or silver, are used in a dispersion slurry for superfine printing, the price rate of the production of this dispersion slurry becomes high since the material itself is expensive. This is a large economical handicap against a spread of the slurry into wide fields as a widely usable article. Furthermore, about silver nanoparticles, a drawback of a fall in electric non-conductivity between circuits, resulting from electromigration, becomes a larger problem as the wiring line width and space-distance between the wiring lines are made narrower.

For metal nanoparticle dispersed slurries for forming fine wiring, it is expected to use copper, which causes little electromigration, and is considerably smaller in the price rate of material itself than gold or silver. Copper particles have a nature of being more easily oxidized than noble metals. Thus, as a surface treating agent therefor, there is used an agent having an antioxidation effect besides an effect for dispersibility-improving purpose. For such purposes, the following is used: a polymer having a substituent which interacts with the copper surface; or a surface treating agent having a long-chain alkyl group (see, for example, Patent Documents 3 and 4).

Patent Document 1: Japanese Patent Application Laid-Open (JP-A-) No. 2004-273205
Patent Document 2: JP-A No. 2003-203522
Patent Document 3: Japanese Patent No. 3599950
Patent Document 4: JP-A No. 2005-081501

### Disclosure of the Invention

### Problems to be solved by the Invention

Table 1 shows a theoretical treating agent amount in a case where the surface of particles of each species is monomolecular-layer-treated (coated with a monomolecular film). About the particles having a particle diameter of 100 nm, the proportion occupied by the treating agent becomes as large as 8% by volume. As the particles become particles having a smaller particle diameter, the proportion of the surface treating agent becomes larger. In particular, in surface treatment for causing copper to have antioxidative effect, or some other treatment, larger molecules than the molecules used for the calculation are used; thus, the proportion occupied by the surface treating agent becomes still larger. In order to remove this surface treating agent, the contained amount of which is large, large energy is required. Thus, under the present situation, the particles containing the treating agent are not easily sintered the temperature of 200°C or less. Additionally, the surface treating agent, which cannot be sufficiently removed, and cracks based on shrinkage of the volume cause a problem that the copper particles are not turned to have a low resistance at low temperature.

**[Table 1]**

| Treating agent amounts necessary for monomolecular-film-coating of the surface of copper particles different in particle diameter | | | |
|---|---|---|---|
| Particle diameter [nm] | Specific surface area (m²/m³) of particles | Proportion (% by mass) occupied by treating agent | Proportion (% by volume) occupied by treating agent |
| 10,000 | 3 × 10⁵ | 0.01 | 0.09 |
| 1,000 | 3 × 10⁶ | 0.1 | 0.9 |
| 100 | 3 × 10⁷ | 1.2 | 8 |
| 50 | 6 × 10⁷ | 2.0 | 15 |
| 10 | 3 × 10⁸ | 9. 2 | 48 |
| 1 | 3 × 10⁹ | 50 | 90 |

The treating agent amounts were each calculated by regarding the copper particles as the single particle diameter and complete spheres, regarding the copper density as 8.96 g/cm³, and further regarding the molecular weight, the minimum coating area and the density of the surface treating agent as 240 g/mol, 330 m²/g and 1 g/cm³, respectively.

An object of the invention is to provide a method wherein a surface treating agent, which is essential for making copper particles antioxidative and dispersing the copper particles in the prior art, is hardly used but copper particles, which cause little electromigration and are small in the price rate of material itself, are used to form a low-resistance copper wiring pattern while the generation of cracks therein is restrained; and a copper oxide particle dispersed slurry used therein.

### Means for solving the Problems

The inventors have investigated drawbacks as described above in detail, so as to conclude that: a surface treating agent, which is essential for making copper particles antioxidative and dispersing the copper particles in the prior art, is a cause for a rise in the sintering temperature, and wire snapping or a rise in the resistance on the basis of cracks; and it is necessary to make use of a method using no surface treating agent. The inventors have made eager investigations on the method so as to find out that copper based particles having a copper oxide surface can be dispersed without using any dispersing agent. However, copper oxide particles are an insulator; thus, it is necessary to return the copper oxide to metallic copper by reduction after the copper oxide particles are formed into a wiring pattern. In particular, in order to prevent re-oxidation after the reduction, it is necessary to sinter the particles at the same time when the particles are reduced. The inventors have investigated a reducing method suitable for this matter, so as to find out that reduction with atomic form hydrogen is effective. As a result, the inventors have found out a novel method for forming a low-resistance conductor pattern according to a combination of these findings. Thus, the invention has been made.

(1) A method for forming a copper wiring pattern, including:
   the step of using a dispersion slurry wherein copper based particles having a copper oxide surface are dispersed to form any pattern over a substrate, and
   the step of reducing the copper oxide surface of the copper based particles in the pattern with atomic form hydrogen to return the oxide to copper, and sintering particles of the copper metal generated by the reduction and bonding the particles to each other.
In the present specification, the "copper based particles" denote particles each having a shell region made of copper oxide and a core region made of a material other than it, or particles the whole of which is made of only copper oxide.

(2) The method for forming a copper wiring pattern according to item (1), wherein the atomic form hydrogen is atomic form hydrogen that is generated by decomposing hydrogen or a compound containing hydrogen on a heated catalytic body surface.

(3) The method for forming a copper wiring pattern according to item (1) or (2), wherein in the step of forming the pattern, the pattern is formed by or with one selected from the group consisting of ink-jetting, screen printing, transfer printing, offset printing, jet printing, a disperser, a comma coater, a slit coater, a die coater, and a gravure coater.

(4) The method for forming a copper wiring pattern according to any one of items (1) to (3),
wherein the number-average particle diameter of the copper based particles having the copper oxide surface in the dispersion slurry is from 1 to 100 nm,
the composition of the copper oxide surface includes cuprous oxide, cupric oxide, or a mixture thereof, and
the dispersion slurry further contains a surface treating agent, and the concentration of the surface treating agent is 1% or less by mass.

(5) The method for forming a copper wiring pattern according to item (4), wherein in the copper based particles, the composition of the copper oxide surface is the same as or different from that of a core region that is other than the copper oxide surface, and the composition of the core region includes metallic copper, cuprous oxide, cupric oxide, or a mixture thereof.

(6) A copper oxide particle dispersed slurry, comprising dispersed copper based particles having a copper oxide surface,
wherein the number-average primary particle diameter of the copper based particles having the copper oxide surface is from 1 to 100 nm,
the composition of the copper oxide surface includes cuprous oxide, cupric oxide, or a mixture thereof, and
a surface treating agent is contained and the concentration of the surface treating agent is 1% or less by mass.

(7) The copper oxide particle dispersed slurry according to item (6), wherein in the copper based particles, the composition of the copper oxide surface is the same as or different from that of a core region that is other than the copper oxide surface, and the composition of the core region includes metallic copper, cuprous oxide, cupric oxide, or a mixture thereof.

### Effects of the Invention

According to the invention, a surface treating agent, which is essential for making copper particles antioxidative and dispersing the copper particles in the prior art, is hardly used; therefore, the particles are easily sintered, and a low-resistance pattern can be formed without being cracked. Thus, it is possible to provide a copper-wiring-pattern forming method that is more inexpensive than conventional noble metal paste and is capable of restraining electromigration; and a copper oxide particle dispersed slurry suitable therefor.

### Brief Description of the Drawings

FIG 1 is a schematic view illustrating the structure of electrodes disposed on a polyimide substrate.
FIG 2 is a schematic view of a hot-wire method atomic-form-hydrogen treatment device.
FIGS. 3 are photographs, substituted for drawings, illustrating the external appearance of a copper oxide particle painted substrate of Example 1 before and after the substrate was subjected to reduction treatment according to a hot-wire method atomic-form-hydrogen treatment device.
FIG 4 is a view showing an optical microscopic image (magnification power: 200) of the copper oxide particle painted product after the treatment.
FIGS. 5 are photographs, substituted for drawing, illustrating the external appearance of a copper oxide particle painted substrate of Example 2 before and after the substrate was subjected to reduction treatment according to the hot-wire method atomic-form-hydrogen treatment device.
FIGS. 6 are photographs, substituted for drawings, illustrating the external appearance of a copper oxide particle painted substrate of Example 3 before and after the substrate was subjected to treatment according to the hot-wire method atomic-form-hydrogen treatment device.
FIGS. 7 are photographs, substituted for drawings, illustrating the external appearance of a copper oxide particle painted substrate of Comparative Example 1 before and after the substrate was subjected to treatment according to the hot-wire method atomic-form-hydrogen treatment device.
FIG 8 is a view showing an optical microscopic image (magnification power: 200) of the copper oxide particle painted product of Comparative Example 1 after the treatment.

### Description of Reference Numerals

- 10: hot-wire method atomic-form-hydrogen treatment device
- 12: gas introduction port
- 14: shower head
- 16: exhaust port
- 18: substrate holding region
- 20: temperature adjustor
- 22: catalytic body
- 24: shutter
- 30: substrate
- 32: wiring

### Best Mode for Carrying Out the Invention

The method of the invention for forming a copper wiring pattern includes the step of using a dispersion slurry wherein copper based particles having a copper oxide surface are dispersed to form any pattern over a substrate, and the step of reducing the copper oxide component of the copper based particles in the pattern with atomic form hydrogen to return the oxide to copper, and sintering particles of the copper metal generated by the reduction and bonding the particles to each other. Hereinafter, each of the steps of the copper-wiring-pattern forming method of the invention will be described.

### <Step of forming any pattern over a substrate>

The present step is the step of using a dispersion slurry wherein copper based particles having a copper oxide surface are dispersed to form any pattern over a substrate. First, the substrate will be described.

### [Substrate]

Specific examples of the material of the substrate used in the copper-wiring-pattern forming method of the invention include polyimide, polyethylene naphthalate, polyethersulfone, polyethylene terephthalate, polyamideimide, polyetheretherketone, polycarbonate, liquid crystal polymer, epoxy resin, phenol resin, cyanate ester resin, fiber reinforced resin, inorganic particle filled resin, polyolefin, polyamide, polyphenylene sulfide, polypropylene, crosslinked polyvinyl resin, glass and ceramics.

When hot-wire method CVD, which will be described later, is used in the reducing/sintering step in the invention, treatment at high temperature is not required. Thus, restraints onto the used substrate get fewer. For example, a substrate low in heat resistance may be used.

### [Dispersion slurry]

In the copper-wiring-pattern forming method of the invention, the dispersion slurry used to form the wiring pattern is a dispersion slurry wherein copper based particles having a copper oxide surface are dispersed. Hereinafter, the dispersion slurry will be described in detail.

### (Copper based particles)

In the invention, the copper based particles contained in the dispersion slurry preferably have a particle diameter of a degree permitting the particles not to be speedily sedimented by the weight of the particles themselves. From this viewpoint, the number-average primary particle diameter is preferably from 1 to 500 nm. This particle diameter is also restrained by a method for drawing the wiring, or the wiring line width. In the case of using ink-jet printing, the particle diameter needs to be 100 nm or less not to choke the nozzle. The particle diameter also needs to be a particle diameter not more than a target wiring line width or target space-distance between wiring lines. From the above-mentioned matters, about the copper based particles according to the invention, the number-average primary particle diameter is preferably from 1 to 100 nm, more preferably from 5 to 80 nm, even more preferably from 10 to 50 nm.

The copper based particles used in the invention have a copper oxide surface. The composition of the copper oxide surface is preferably made of cuprous oxide, cupric oxide, or a mixture thereof for the following reason: A metal element made exposed to the surface of the metal is in a state that its metallic bonds are cleaved on the surface side, and is in a high energy state; therefore, the metal surface has a high surface energy, so that particles having the metal surface cannot be stably dispersed, thereby being aggregated. This is remarkable, in particular, about nanoparticles having a large specific surface area. On the other hand, in a case where particles having, cupric oxide, in their surface, which is non-conductive, the particles are smaller in surface energy so as to be more easily dispersed than metal particles. For this reason, the particles can be dispersed with a small amount of a dispersing agent. In accordance with the selection of a dispersing medium or the particles, the particles can be dispersed even when no dispersing agent is used.
The atomic form hydrogen used in the invention, which results from HW-CDV, has a high reducing power so as to make it possible to reduce copper oxide to copper at low temperature. Thus, copper oxide particles, or core-shell particles having a surface made of copper oxide can be used, and it is unnecessary to give a protective agent for antioxidation to the surface of the copper particles.

In the copper based particles, the composition of the copper oxide surface may be the same as or different from that of a core region that is other than the copper oxide surface, and the composition of the core region is preferably made of metallic copper, cuprous oxide, cupric oxide, or a mixture thereof.

The dispersing medium used when the dispersion slurry containing the particles is prepared may be, for example, a ketone solvent such as acetone, methyl ethyl ketone, γ-butyrolactone or cyclohexanone, a polar solvent such as dimethylacetoamide, N-methylpyrrolidone or propylene glycol monoethyl ether, or a hydrocarbon solvent such as toluene or tetradecane.

In the preparation of the dispersion slurry, a surface treating agent may be used. However, the use of a surface treating agent causes the above-mentioned bad effect; thus, the use thereof is preferably kept to a minimum. Specifically, the amount thereof is preferably less than 1% by mass, more preferably less than 0.5% by mass. As the case may be, a surface treating agent may not be used at all. The same matter as described about the surface treating agent is applicable to a dispersing agent. The use amount thereof is preferably made as small as possible if the dispersing agent comes to hinder the sintering.

The dispersion of the copper based particles can be attained by use of an ultrasonic disperser, a medium disperser such as a bead mill, a cavitation stirring device such as a homomixer, or a Silverson mixer, a counter collision method such as an Ultimizer, a superthin-film high-speed-rotation type disperser such as a Clear SS5, an autorotating and revolving mixer, or the like.

The concentration of the particles in the dispersion slurry is set preferably into the range of 1 to 70% by mass, more preferably into that of 5 to 60% by mass, even more preferably into that of 10 to 50% by mass.

### [Formation of any wiring pattern]

The method for forming any wiring pattern over the substrate by use of the dispersion slurry may be printing or applying that has been hitherto used to paint ink. In order to draw the wiring pattern, the above-mentioned painting slurry is used and any one selected from the group consisting of the following may be used: ink-jetting, screen printing, transfer printing, offset printing, jet printing, a disperser, a comma coater, a slit coater, a die coater, an ink-jet coater and a gravure coater.

After the formation of the wiring pattern by use of the painting slurry is finished, the workpiece is dried at a temperature matching with the volatility of the dispersing medium. At this time, the copper based particles according to the invention do not need to be dried in an atmosphere from which oxygen is removed as in the case of metallic copper particles since the surface of the copper based particles is made of copper oxide.

### [Reduction and sintering based on atomic form hydrogen]

After the substrate over which the wiring pattern is formed by use of the copper based particles is dried, the substrate is subjected to reduction treatment with atomic form hydrogen. The method for generating the atomic form hydrogen may be a method of decomposing hydrogen or a compound containing hydrogen on the surface of a heated catalytic body to generate the hydrogen, that is, hot-wire CVD method (catalytic chemical vapor deposition). Hereinafter, this will be described, giving a method based on hot-wire CVD as an example.

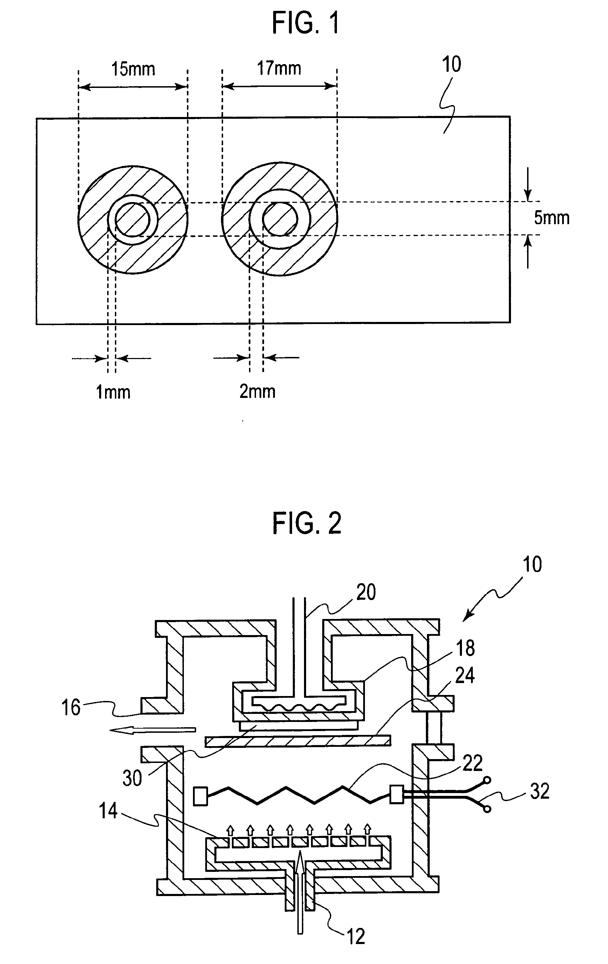

FIG 2 is a view which schematically illustrates the inside of a chamber of a hot-wire method device 10 for treatment with atomic form hydrogen. The hot-wire method atomic-form-hydrogen treatment device 10 has a gas introduction port 12 from which a gas from the outside is introduced into the chamber; a shower head 14 for diffusing the gas introduced from the gas introduction port 12 inwards; an exhaust port 16 connected to an external pressure-reducing pump; a substrate holding region 18 for holding a substrate 30 to be subjected to reduction; a temperature adjustor 20 for adjusting the temperature of the substrate holding region 18; a catalytic body 22 that is connected through wiring lines 32 to an external power source, and receives conducted electricity to generate heat; and a shutter 24 which is positioned between the catalytic body 22 and the substrate 30 and shields radiant heat generated from the catalytic body 22.

When the substrate after the wiring pattern is formed is reduced and sintered, the substrate 30 is set into the substrate holding region 18 and then the pressure in the device is reduced to 1 × 10⁻³ Pa or less to exhaust the air in the system. Next, from the gas introduction port 12, a raw material gas containing hydrogen, such as hydrogen, ammonia or hydrazine, is sent into the shower head 14 for diffusing any gas in the chamber. Electricity is sent to the catalytic body 22 positioned between the shower head 14 and the substrate 30 to heat the catalytic body 20 to high temperature, thereby decomposing the raw material gas by a catalytic effect of the catalytic body 22 to generate atomic form hydrogen. When this atomic form hydrogen reaches the wiring pattern of the substrate 30, copper oxide particles in the wiring pattern are reduced so that the sintering thereof advances. The substrate 30 does not receive radiant heat directly from the catalytic body 22 by effect of the shutter 24, which has gaps that do not block any gas, between the catalytic body 22 heated to high temperature and the substrate 30. During this treatment, the temperature of the substrate 30 is varied below 50°C unless the substrate 30 receives radiant heat directly from the catalytic body 22 or the holder 18 is heated. At such a low temperature, however, at the same time when the copper particles are reduced, the reduced copper particles are sintered so that bonding between the particles advances. Since the copper oxide particles used in the formation of the pattern contain no surface treating agent, the shrinkage of the volume is restrained into a minimum at the time of the treatment with the atomic form hydrogen. As a result, the treated copper pattern exhibits a high electroconductivity. Since the substrate temperature is a very low temperature of 50°C or lower at the time of the atomic form hydrogen treatment, a deformation or discoloration of the substrate which follows the treatment is restrained to the lowest even when the substrate is a plastic substrate.

The hydrogen-containing compound for generating the atomic form hydrogen may be methane gas beside ammonia or hydrazine described above. Of the compounds, ammonia or hydrazine is preferred.

As the catalytic body used to generate the atomic form hydrogen from hydrogen or the compound, molybdenum besides tungsten may be used.
Such a catalytic body may be made into a cylindrical form, a plate form, or a cotton form besides a wire form as described above.
In the above-mentioned treatment, the catalytic body is heated; the heating temperature is set preferably into the range of 800 to 3300°C, more preferably into that of 1000 to 2500°C, even more preferably into that of 1200 to 2000°C. In the case of a tungsten wire as described above, sending electricity thereto makes it possible to cause the wire to generate heat.

As described above, the sintering advances simultaneously with the reduction. It is therefore unnecessary that the substrate after the wiring pattern is formed is heated for the purpose of sintering the substrate.

According to the copper-wiring-pattern forming method of the invention, low-resistance copper conductor wiring restrained from being cracked is produced.

### <Copper oxide particle dispersed slurry>

The copper oxide particle dispersed slurry of the invention is a copper oxide particle dispersed slurry wherein copper based particles having a copper oxide surface are dispersed, and is a slurry wherein the number-average primary particle diameter of the copper based particles having the copper oxide surface is from 1 to 100 nm, the composition of the copper oxide surface includes cuprous oxide, cupric oxide, or a mixture thereof, and further a surface treating agent is contained and the concentration of the surface treating agent is 1% or less by mass.
In the copper based particles, the composition of the copper oxide surface may be the same as or different from that of a core region that is other than the copper oxide surface, and the composition of the core region preferably includes metallic copper, cuprous oxide, cupric oxide, or a mixture thereof.

The copper oxide particle dispersed slurry of the invention is a slurry that is used suitably in the copper-wiring-pattern forming method of the invention. The slurry acts synergetically with the copper-wiring-pattern forming method of the invention, whereby low-resistance copper conductor wiring can be produced while the generation of cracks is restrained. Detailed contents thereof are the same as in the description of the dispersion slurry in the copper-wiring-pattern forming method of the invention; thus, description thereof is omitted.

### Examples

Hereinafter, the invention will be specifically described by way of examples; however, the invention is not limited to the examples.

### [Example 1]

### (Preparation of a copper oxide dispersed slurry)

Copper oxide particles (cupric oxide, product name: NanoTek CuO, manufactured by C. I. Kasei Co., Ltd.) having a number-average primary particle diameter of 50 nm were added to γ-butyrolactone to give a proportion of 10% by mass. Ultrasonic waves were applied to the slurry for 20 minutes to yield a copper oxide dispersed slurry. No surface treating agent was added to this dispersion slurry.

### (Formation of a copper oxide particle painted substrate)

An applicator having a gap of 150 µm was used to paint this dispersion slurry onto a polyimide substrate (trade name: MCF5000I, manufactured by Hitachi Chemical Co., Ltd.) having a copper foil pattern illustrated in FIG 1 (hatched areas in FIG. 1), and then the workpiece was dried on a hot plate of 100°C temperature for 20 minutes. The painting and drying were again repeated to yield a copper oxide particle painted substrate.

### (Reduction and sintering based on atomic form hydrogen)

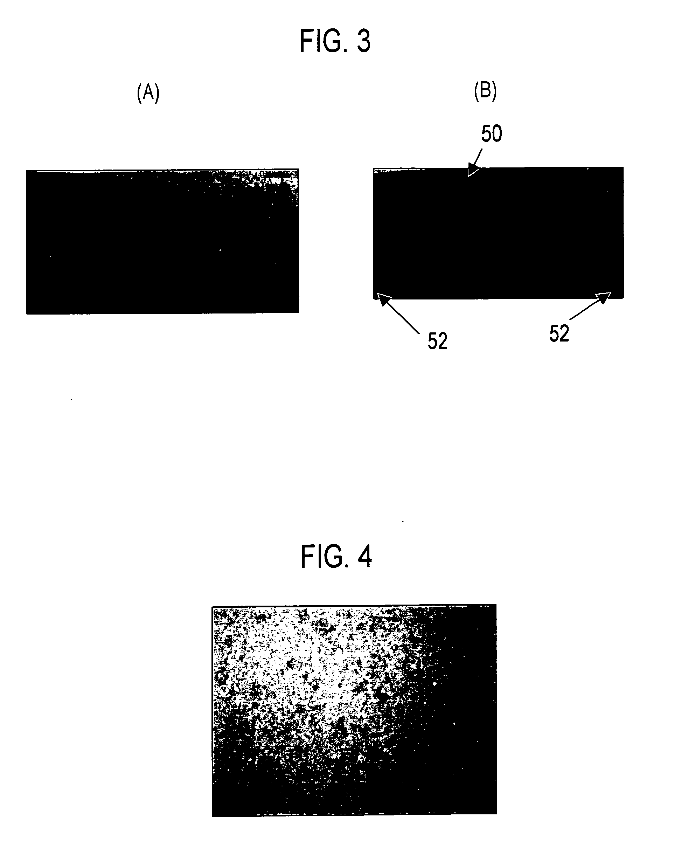

The yielded copper oxide particle painted substrate was set in a hot-wire method atomic-form-hydrogen treatment device having a structure as illustrated in FIG 2, and then the substrate was treated for 20 minutes under conditions that the hydrogen was 50 mL/min., the tungsten wire temperature was 1500°C, the pressure was 4 Pa and the stage temperature (the temperature of the substrate holding region) was 40°C. The sending of electricity to the tungsten wire and the hydrogen were stopped, and then the workpiece was cooled for 10 minutes. Thereafter, the pressure was returned to normal pressure, and the treated particle painted substrate was taken out. As a result, as illustrated in FIGS. 3, the particle painted product that had been black before the treatment was reddish brown after the treatment. FIGS. 3 are each a photograph obtained by photographing the surface of the copper oxide particle painted substrate, and FIG 3 (A) shows that before the reduction and FIG 3(B) shows that after the reduction. In FIG 3(B), reference 50 represents a reduced region and reference numbers 52 show regions not reduced by the contact of a tool therewith.
FIG 4 shows a microscopic photograph after the treatment (after the reduction). It is understood from FIG. 4 that this treated particle painted product was a homogeneous film having no crack. The treated painted film was subjected to cutting work by an FIB, and a cross section thereof was observed by SIM. As a result, the film thickness was 2 µm. In the treated particle painted substrate, the resistances between the individual concentric electrode pairs in FIG. 1 were each measured with a tester (CD800a, manufactured by Sanwa Electric Instrument Co., Ltd.). As a result, in the case where the distance between the electrodes was 1 mm, the resistance was 0.0 Ω, and in the case where the distance was 2 mm, the resistance was 0.1 Ω. In the measurement thereof before the reduction, the resistances between the concentric electrode pairs were each not less than the measurement limit. In other words, the electrode pairs each conducted no electricity therebetween.

### [Example 2]

### (Preparation of a copper oxide dispersed slurry)

A cupric oxide reagent (manufactured by Kanto Chemical Co., Inc.) was put into acetone. While the resultant slurry was stirred, the slurry was irradiated with a UV YAG laser having a wavelength of 1064 nm at 10 Hz for 30 minutes. The resultant black slurry was centrifuged at 12000 rpm for 10 minutes, and the coarse particles were removed as a precipitation to yield a dispersion slurry of copper particles having a surface coated with copper oxide, wherein the number-average primary particle diameter was 100 nm.

### (Formation of a copper-oxide-coated copper particle painted substrate)

The resultant dispersion slurry was concentrated to produce a 5% by mass concentrated slurry. An applicator having a gap of 150 µm was then used to paint this dispersion slurry onto a polyimide substrate (trade name: MCF5000I, manufactured by Hitachi Chemical Co., Ltd.) having a copper foil pattern illustrated in FIG. 1. The workpiece was then dried on a hot plate of 100°C temperature in a nitrogen atmosphere for 10 minutes. The painting and drying were repeated 7 times to yield a substrate on which the copper particles coated with copper oxide were painted.

### (Reduction and sintering based on atomic form hydrogen)

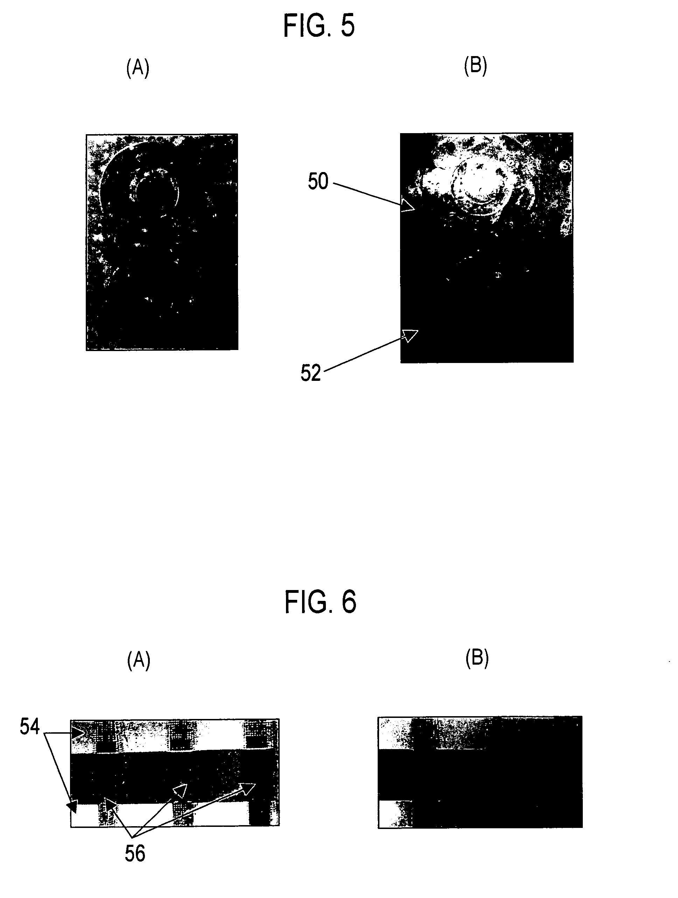

The yielded copper particle painted substrate was treated by means of the hot-wire method atomic-form-hydrogen treatment device in the same way as in Example 1. As a result, the particle painted product that had been black before the treatment was in copper color (FIGS. 5). FIGS. 5 are each a photograph obtained by photographing the surface of the copper oxide particle painted substrate, and FIG. 5(A) shows that before the reduction and FIG 5(B) shows that after the reduction. In FIG. 5(B), reference 50 represents a reduced region and reference number 52 shows a region not reduced by the contact of a tool therewith. The treated painted film was subjected to cutting work by an FIB, and a cross section thereof was observed by SIM. As a result, the film thickness was 2 µm. In the treated particle painted substrate, the resistances between the individual concentric electrode pairs in FIG 1 were each measured with a four-probe method micro-resistivity meter (Loresta MCP-T610, manufactured by Mitsubishi Chemical Corp.). As a result, in the case where the distance between the electrodes was 1 mm, the resistance was 9.6 × 10⁻³ Ω, and in the case where the distance was 2 mm, the resistance was 3.6 × 10⁻² Ω. When the volume resistivities were converted, the resultant values were 2.4 × 10⁻⁸ Ω m, and 9.1 × 10⁻⁸ Ω m, respectively. In the measurement thereof before the reduction, the resistances between the concentric electrode pairs were each not less than the measurement limit. In other words, the electrode pairs each conducted no electricity therebetween.

### [Example 3]

The 12% by weight copper-nanoparticle solution used in Example 2 was used to make a print by means of an ink-jet printer, thereby yielding a sample wherein copper-nanoparticle painted film was patterned into a rectangular form by the ink-jet printing. FIG. 6(A) is a photograph obtained by photographing the surface of the resultant sample. In the figure, reference number 54 represents electrodes made of copper foil, and reference number 56 represents ink-jet printed copper-nanoparticle painted film. This copper particle painted substrate, which was formed by the ink-jet printing, was treated by means of the hot-wire method atomic-form hydrogen treatment device in the same way as in Example 1. As a result, the particle painted product that had been black before the treatment was in copper color. Fig. 6(B) is a photograph obtained by photographing the surface of the treated (reduced) sample. The treated painted film was subjected to cutting work by an FIB, and a cross section thereof was observed by SIM. As a result, the film thickness was 3 µm. In the treated particle painted substrate, the resistances between the copper foil electrodes (distance between the electrodes: 5 mm) were measured with a tester (CD800a, manufactured by Sanwa Electric Instrument Co., Ltd.). As a result, the resistances were 3.8 Ω (volume resistivity: 5 × 10⁻⁶ Ωm). In the measurement thereof before the reduction, the resistances between the electrodes were each not less than the measurement limit. In other words, the electrodes conducted no electricity therebetween.

### [Comparative Example 1]

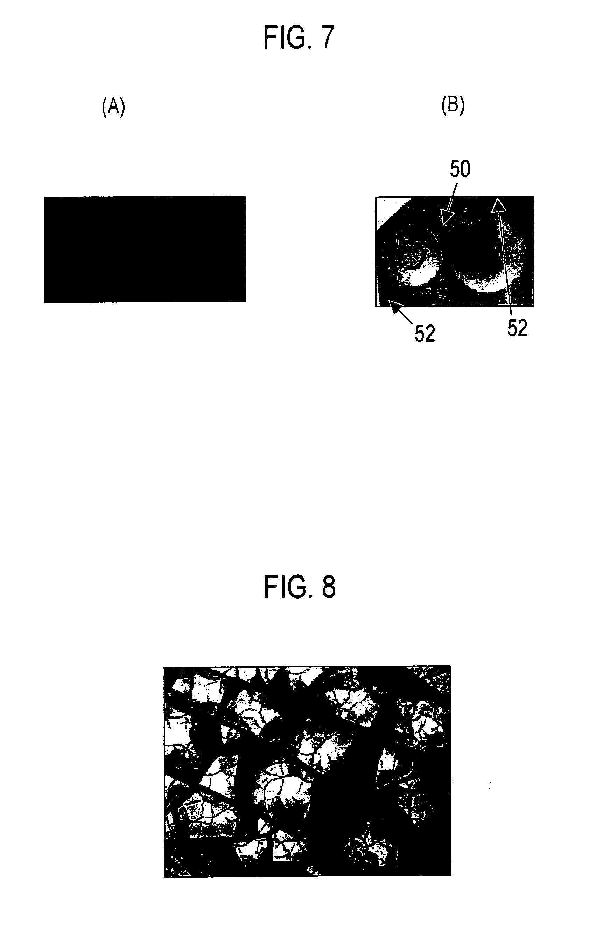

An applicator having a gap of 100 µm was then used to paint a 30% by weight dispersion slurry of copper particles includes a surface treatment (antioxidative) agent (Cu1T, manufactured by ULVAC Inc.) having a number-average primary particle diameter of 3 nm or less in toluene onto the same substrate as in Example 1. The workpiece was then dried on a hot plate of 100°C temperature in a nitrogen gas flow for 5 minutes. The painting and drying were again repeated to yield a copper particle painted substrate. FIG 7(A) is a photograph obtained by photographing the surface of the resultant copper particle painted substrate. This copper particle painted substrate was treated by means of the hot-wire method atomic-form-hydrogen treatment device under the same conditions as in Example 1. The particle painted product that had been black before the treatment (FIG. 7(A)) was changed to a copper glossy product wherein thin pieces were to be easily peeled (FIG 7(B)). In FIG. 7(B), reference 50 represents a reduced region and reference numbers 52 show regions not reduced by the contact of a tool therewith.

FIG. 8 shows a microscopic photograph thereof after the treatment (after the reduction). According to the microscopic observation, it is understood that large and small cracks were generated in the treated particle painted product. Before and after the reduction, the resistances between the electrodes were each not less than the measurement limit. Thus, the electrodes conducted no electricity therebetween. The copper particle dispersed slurry used in the present investigation, which had the surface treating agent, was dried at 30°C in a vacuum drying device for 5 hours. The carbon content by percentage in the resultant particles was then measured. As a result, carbon was detected in an amount of 21.25% by mass. The kind of the surface treating agent was unclear; however, when a calculation was made on the supposition that the detected carbon originated from methylene groups of the surface treating agent, the surface treating agent was contained in an amount of 38% or more by mass of the metallic copper.

### [Comparative Example 2]

The substrate used in Example 2, on which the copper particles coated with copper oxide were painted, was heated to 200 degrees at normal pressure in a hydrogen gas flow, so as to be treated for 1 hour. As a result of the treatment, the product, wherein the copper particles coated with copper oxide were painted, that had been black was discolored into dark brown. Before and after the reduction, the resistances between the electrodes were each not less than the measurement limit. Thus, the electrodes conducted no electricity therebetween.

The results of Examples 1 to 3 and Comparative Examples 1 are shown in Table 2 described below.

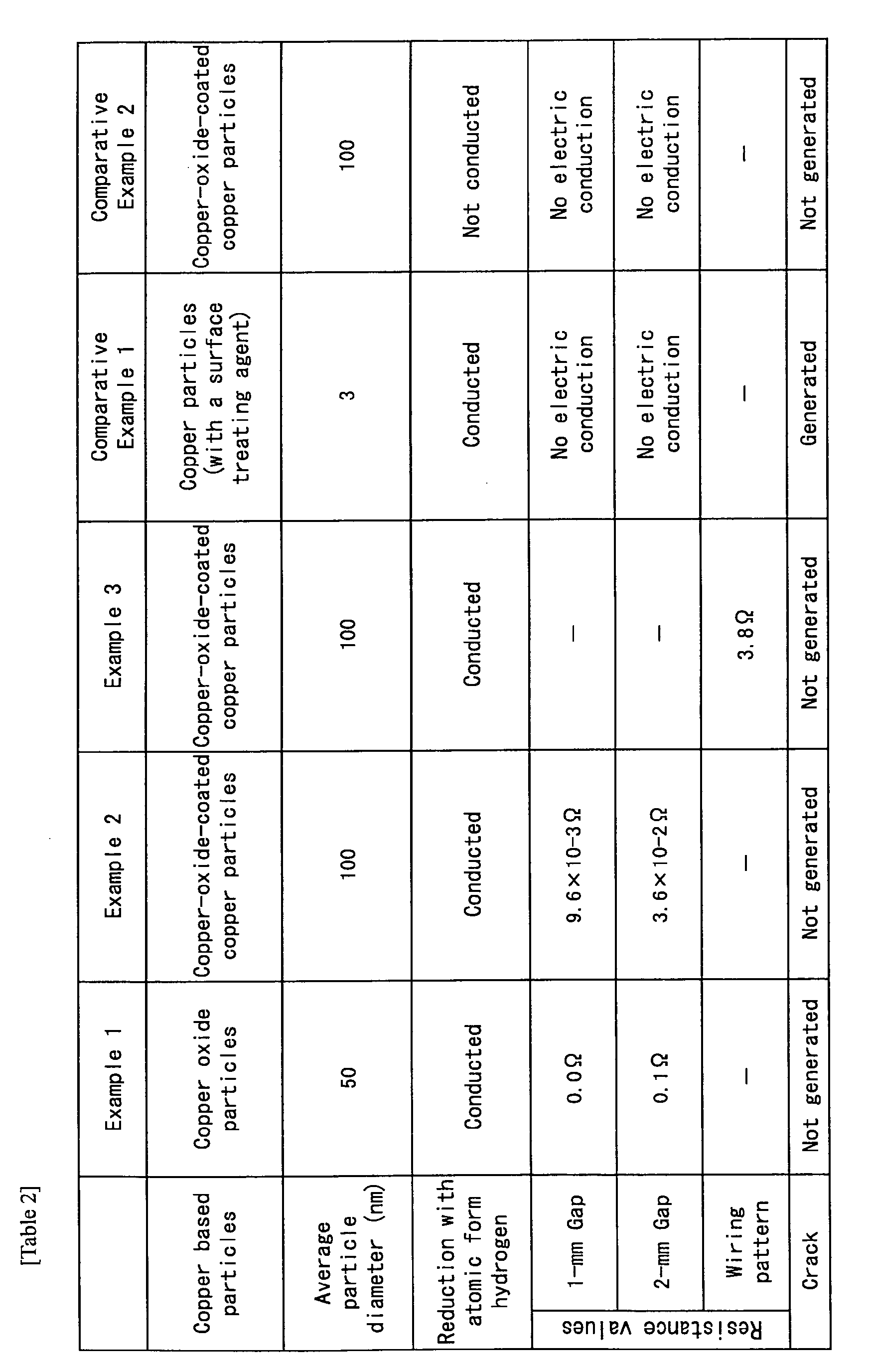

According to Table 2, in Examples 1 to 3, low-resistance copper conductor wiring wherein no crack was generated was yielded. On the other hand, in Comparative Example 1, cracks were generated and further no electric conduction was caused.

## Claims

1. A method for forming a copper wiring pattern, comprising:
the step of using a dispersion slurry wherein copper based particles having a copper oxide surface are dispersed to form any pattern over a substrate, and
the step of reducing the copper oxide surface of the copper based particles in the pattern with atomic form hydrogen to return the oxide to copper, and sintering particles of the copper metal generated by the reduction and bonding the particles to each other.

2. The method for forming a copper wiring pattern according to claim 1, wherein the atomic form hydrogen is atomic form hydrogen that is generated by decomposing hydrogen or a compound containing hydrogen on a heated catalytic body surface.

3. The method for forming a copper wiring pattern according to claim 1 or 2, wherein in the step of forming the pattern, the pattern is formed by or with one selected from the group consisting of ink-jetting, screen printing, transfer printing, offset printing, jet printing, a disperser, a comma coater, a slit coater, a die coater, and a gravure coater.

4. The method for forming a copper wiring pattern according to any one of claims 1 to 3,
wherein the number-average particle diameter of the copper based particles having the copper oxide surface in the dispersion slurry is from 1 to 100 nm,
the composition of the copper oxide surface comprises cuprous oxide, cupric oxide, or a mixture thereof, and
the dispersion slurry further contains a surface treating agent, and the concentration of the surface treating agent is 1% or less by mass.

5. The method for forming a copper wiring pattern according to claim 4, wherein in the copper based particles, the composition of the copper oxide surface is the same as or different from that of a core region that is other than the copper oxide surface, and the composition of the core region comprises metallic copper, cuprous oxide, cupric oxide, or a mixture thereof.

6. A copper oxide particle dispersed slurry, comprising dispersed copper based particles having a copper oxide surface,
wherein the number-average primary particle diameter of the copper based particles having the copper oxide surface is from 1 to 100 nm,
the composition of the copper oxide surface comprises cuprous oxide, cupric oxide, or a mixture thereof, and
a surface treating agent is contained and the concentration of the surface treating agent is 1% or less by mass.

7. The copper oxide particle dispersed slurry according to claim 6, wherein in the copper based particles, the composition of the copper oxide surface is the same as or different from that of a core region that is other than the copper oxide surface, and the composition of the core region comprises metallic copper, cuprous oxide, cupric oxide, or a mixture thereof.
